# EUROPÄISCHE PATENTSCHRIFT

(11) **EP 1 045 455 B1**
(45) Veröffentlichungstag und Bekanntmachung des Hinweises auf die Patenterteilung: **25.04.2007**
(21) Anmeldenummer: 00106280.1
(22) Anmeldetag: 23.03.2000
(51) Int. Cl.: H01L 31/042

(54) **Schaltungsanordnung zur Stromerzeugung mit Solarzellen**
Circuit arrangement for power generation with solar cells
Circuit pour la génération de courant avec des cellules solaires

(30) Priorität: 13.04.1999 DE 19916742
(43) Veröffentlichungstag der Anmeldung: 18.10.2000
(73) Patentinhaber: SCHOTT Solar GmbH, 63755 Alzenau (DE)
(72) Erfinder: Dickmann, Peter, 63589 Grossenhausen (DE)
(74) Vertreter: Stoffregen, Hans-Herbert

(56) Entgegenhaltungen:
- DE-A- 3 707 626
- US-A- 3 437 818
- US-A- 4 567 316
- PATENT ABSTRACTS OF JAPAN vol. 017, no. 137 (E-1335), 22. März 1993 (1993-03-22) & JP 04 306884 A (CANON INC), 29. Oktober 1992 (1992-10-29)
- PATENT ABSTRACTS OF JAPAN vol. 011, no. 249 (E-532), 13. August 1987 (1987-08-13) & JP 62 060273 A (CASIO COMPUT CO LTD), 16. März 1987 (1987-03-16)

## Beschreibung

Die Erfindung bezieht sich auf eine Schaltungsanordnung nach dem Oberbegriff des Anspruchs 1.

Photovoltaik-Anlagen zur Umwandlung von Sonnenenergie in elektrische Energie bestehen aus Solarzellen, die in Modulen angeordnet sind, auf denen Ketten von in Serie geschalteten Solarzellen angeordnet sind, die jeweils durch eine Bypass-Diode überbrückt sind. Ein entsprechendes Solarmodul ist in der US-A-43567,316 beschrieben. Die Ketten sind ebenfalls in Serie geschaltet. Die Module mit den Ketten von Solarzellen sind im Allgemeinen plattenförmig ausgebildet. Auf den Platten befinden sich z. B. Dünnschicht-Solarzellen in Streifen nebeneinander. Die Gegebenheiten am Aufstellungsort der Module lassen es häufig nicht zu, dass an allen Ketten (Strings) eines Moduls die gleiche Einstrahlung herrscht. Es kann vorkommen, dass Ketten durch Objekte in der Nachbarschaft abgeschattet werden und daher keinen Beitrag zur Stromerzeugung mehr leisten.

Um den Betrieb von abgeschatteten Solarzellen, die deshalb in Sperrrichtung gepolt sind, zu vermeiden, werden die Bypass-Dioden eingesetzt, die bei abgeschatteten Ketten in den leitenden Zustand übergehen. Da die Bypass-Dioden beim Betrieb in Durchlassrichtung innere Widerstände haben, treten in ihnen Stromwärmeverluste auf, durch die der Wirkungsgrad der Photovoltaik-Anlage vermindert wird. Die über die Bypass-Dioden fließenden Ströme dürfen die Dioden nicht über zulässige Grenztemperaturen hinaus erwärmen. Es müssen daher Vorkehrungen zur Wärmeableitung durch Konvektion und/oder Strahlung getroffen werden. Beispielsweise werden die Bypass-Dioden auf Kühlkörpern montiert.

Die Ketten (Strings) sind mit Anschlüssen für externe Leitungen versehen. Die Leitungen von bzw. zu den Ketten sind mit ihrem einen Ende in Anschlussboxen angeordnet, in denen die Ketten miteinander verbunden werden.

Wenn zahlreiche Ketten und gegebenenfalls Solarmodule in Reihe geschaltet sind, fließen bei der Abschattung von einzelnen Ketten relativ hohe Ströme über deren Bypass-Dioden. Der Anzahl der abgeschatteten Ketten entspricht die Anzahl der leitenden Bypass-Dioden.

Die Energieausbeute einer Photovoltaik-Anlage wird daher bei abgeschatteten Ketten auch durch die Bypass-Dioden in unerwünschter Weise reduziert.

In Patent Abstract of Japan, Vol. 17, Nr. 137 (1993-03-22), & JP-A-04306884 (29-10-92) ist eine Schaltungsanordnung beschrieben, bei der zu jedem Solarzellenelement eine Bypass-Diode antiparallel geschaltet ist, wobei eine Vielzahl dieser Einheiten bestehend aus Solarzellenelement und Bypass-Diode in Serie zu einem Modul zusammengeschaltet sind. Zwischen einer Anode und einer Kathode dieses so gebildeten Moduls ist ebenfalls antiparallel eine Konstantspannungsdiode geschaltet. Durch diese Maßnahme sollen geringe Variationen der Ausgangsspannung an kleinen Lasten sowie geringe Einbußen aufgrund von Lichtstrahlungen erreicht werden.

In der DE-A-37 07 626 ist ein im Wesentlichen scheibenförmiger Knopf beschrieben, der aus einer ausgehärteten Kunststoffinasse besteht und eine glatte, polierte Oberseite auf weist. In die Kunststoffmasse ist eine Anzahl Leuchtdioden und eine Leiterplatte mit Schaltungselementen zur intermittierenden Ansteuerung der Leuchtdioden eingebettet. Ferner stehen von der Knopfunterseite zwei Anschlussstifte ab, die elektrisch leitend mit Leiterbahnen der Leiterplatte verbunden sind.

Aus Patent Abstracts of Japan, Vol. 011, Nr. 249 (E-532), 13. August 1987, & JP-A-62060273, ist eine Solarbatterie bekannt. Um einen Herstellungsprozess des elektronischen Elementes zu vereinfachen, ist eine Dünnfilmdiode zur Spannungsregulierung vorgesehen.

Aus der US-A-4,567,316 ist ebenfalls ein Solarzellenmodul bekannt. Dieses weist individuelle Solarzellen auf, welche in Reihen angeordnet sind und zumindest teilweise elektrisch in Reihe geschaltet sind und zumindest eine Bypass-Diode aufweisen, die parallel zu zumindest einigen der in Serie geschalteten Solarzellen geschaltet ist. Diese zumindest eine Diode ist während des Betriebs des Solarzellenmoduls normalerweise abgeschaltet und zumindest eine Diode ist unmittelbar in das Solarzellenmodul integriert.

Die US-A-3,437,818 beschreibt einen Schutz von in Serie verbundenen Solarzellen gegen einen offenen Schaltkreis zur Verwendung einer "Shunting Diode". Ziel dieser Erfindung ist es, einen Stromfluss durch einen Array von in Serie geschalteten Solarzellen aufrechtzuerhalten, selbst wenn dieses Array eine geöffnete Verbindung aufweist. Dazu sind alle Verbindungen durch zumindest eine Schutzdiode kurzgeschlossen, wobei jede Verbindung zumindest eine vollständig redundante Kurzschluss-Diode aufweist.

Dem DE 88 15 963 U1 ist ein Solargenerator zu entnehmen, bei dem jedem Solarzellenmodul eine Shuntdiode und dieser eine lichtemittierende Diode parallel geschaltet ist, um ein defektes Solarzellenmodul optisch schnell ermitteln zu können.

Der Erfindung liegt das Problem zu Grunde, eine Schaltungsanordnung mit Solarzellen, die in Ketten in Serie geschaltet sind und je Kette mit einer Bypass-Diode versehen sind, dahingehend weiterzuentwickeln, dass der zu der Anzahl der abgeschatteten bzw. nichtleitenden Ketten proportionale Anstieg der Verlustleistung durch Ströme in den Bypass-Dioden bei zwei und/oder mehr nichtleitenden Ketten in einer Serie von Ketten wesentlich vermindert wird.

Das Problem wird durch die kennzeichnenden Merkmale des Anspruchs 1 gelöst. Wenn bei der erfindungsgemäßen Schaltung diejenigen in Reihe geschalteten Ketten, deren Bypass-Dioden durch eine parallele Diode überbrückt sind, in Sperrrichtung, z. B. durch Abschattung, gepolt sind, dann fließt der Strom über die parallele Diode, wodurch die Verlustleistung nur noch in einer Diode auftritt. Bei jeweils zwei durch eine parallele Diode überbrückten Bypass-Dioden wären im Falle aller in Sperrrichtung gepolten, aus einer geraden Anzahl bestehenden Ketten nur noch halb so viele Dioden stromführend wie Bypass-Dioden vorhanden sind.

Hieraus ist die erhebliche Reduzierung der Verlustleistung bei der erfindungsgemäßen Schaltung ersichtlich. Die Verlustleistung in Dioden kann durch weitere Dioden, die mehrere Bypass-Dioden überbrücken, noch stärker vermindert werden.

Bei einer zweckmäßigen Ausführungsform sind die Bypass-Dioden und die zu diesen parallelen Dioden für zwei oder mehr Ketten auf einer Seite der Leiterplatte angeordnet, auf deren anderen Seite Leiterbahnen mit Anschlussstellen für externe Leitungen und mit durchkontaktierten Löchern für die Anschlüsse der Bypass-Dioden und Dioden vorgesehen sind, wobei Metallflächen als Auflageflächen für die Bypass-Dioden und Dioden auf der Oberfläche der Leiterplatte vorhanden sind. Bei dieser Ausführungsform findet ein Wärmeübergang von den Bypass-Dioden und den weiteren Dioden zu den Metallflächen statt. Da immer nur wenige der auf der Leiterplatte angeordneten Dioden auch bei einer größeren Anzahl der nichtleitenden Ketten stromführend sind, reicht die Platte mit den Metallflächen für die Wärmeabführung aus. Die Leiterplatte mit den Bypass-Dioden und den diese überbrückenden Dioden beansprucht nur wenig Raum. Vorzugsweise ist die Leiterplatte mit den Bypass-Dioden und weiteren Dioden für eine größere Anzahl von Ketten in einer Anschlussdose angeordnet.

Vorzugweise werden als Bypass-Dioden und als Dioden, die zu den Bypass-Dioden parallel liegen, Schottky-Dioden eingesetzt. Schottky-Dioden haben einen geringen Innenwiderstand in Durchlassrichtung. Hieraus ergeben sich geringe Spannungsabfälle und Wärmeverluste.

Weitere Einzelheiten, Merkmale und Vorteile der Erfindung ergeben sich nicht nur aus den Ansprüchen, den diesen zu entnehmenden Merkmalen für sich und/oder in Kombination - , sondern auch aus der nachfolgenden Beschreibung eines in einer Zeichnung dargestellten bevorzugten Ausführungsbeispiels.

Es zeigen:
- Fig. 1: ein Schaltbild einer Anordnung zur Stromerzeugung mit Solarzellen,
- Fig. 2: eine Anschlussbox von innen mit einer Leiterplatte für die Verbindung von in Ketten jeweils in Serie angeordneten Solarzellen mit Bypass-Doden und zu diesen Dioden parallel gelegten Dioden im Schema.

Eine Schaltungsanordnung zur Stromerzeugung weist eine größere Anzahl von Solarzellen auf, von denen in der Zeichnung nur die Solarzellen 10, 12, 14, 16, 18, 20, 22, 24, 26, 28, 30 und 32 dargestellt sind. Die Solarzellen 10 bis 32 sind in Ketten (Strings) 34, 36, 38, 40, 42 und 44 angeordnet, die in der Zeichnung durch gestrichelte Umrandungen dargestellt sind. In der Kette 34 befinden sich die Solarzellen 10, 12, die mit weiteren, nicht dargestellten Solarzellen in Serie geschaltet sind. Die Kette 36 enthält die Solarzellen 14, 16 und weitere in Serie geschaltete, nicht dargestellte Solarzellen. In gleicher Weise sind die Solarzellen 18, 20, bzw. 22, 24 bzw. 26, 28 bzw. 30, 32 jeweils in den Ketten 38 bzw. 40 bzw. 42 bzw. 44 in Serie mit nicht dargestellten, weiteren Solarzellen angeordnet. Jede Kette 34 bis 44 enthält z. B. zwanzig Solarzellen, wodurch unter den genormten Einstrahlungsbedingungen und 25°C Temperatur eine Spannung von ca. 10 V bei 3 A erzeugt wird.

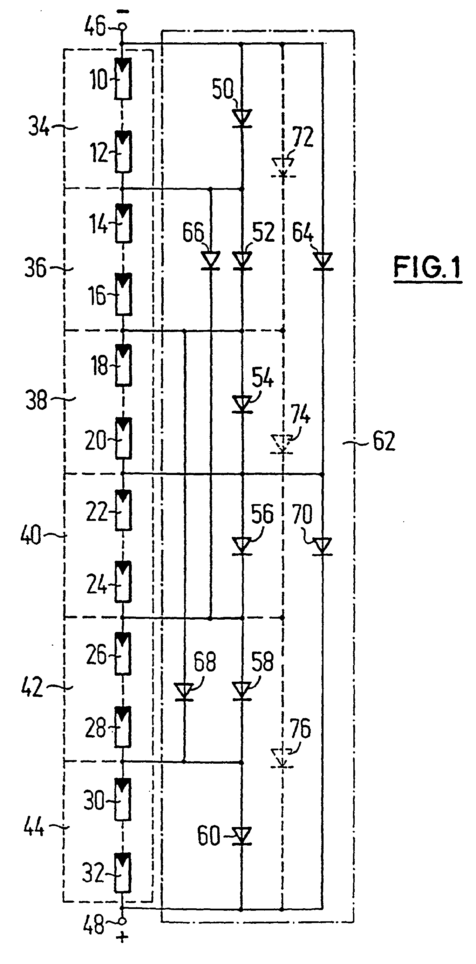

Die Ketten 34 bis 44 sind ebenfalls in Serie geschaltet. Die in Fig. 1 dargestellte Anordnung zeigt daher unter den vorstehend erwähnten Bedingungen 60 V bei 3 A an, wobei die Anschlussstelle 48 positiv ist. Die Anschlussstellen 46, 48, die Solarzellen 10 bis 32 und die nicht dargestellten weiteren Solarzellen sind Bestandteil eines nicht näher dargestellten Solarmoduls, das einen plattenförmigen Aufbau hat. Auf der ebenen Platte des Solarmoduls sind die Solarzellen 10 bis 32 und die nicht dargestellten Solarzellen in Streifen angeordnet. Das in Fig. 1 dargestellte Solarmodul mit den Solarzellen 10 bis 32 und den nicht dargestellten weiteren Solarzellen kann mit einer oder mehreren Solarmodulen, die z. B. den gleichen Aufbau haben, in Serie geschaltet sein. Das Solarmodul gemäß Fig. 1 bzw. die aus mehreren gleichartigen Solarmodulen bestehende Anordnung speist einen Verbraucher, bzw. ist mit einem Wechselrichter verbunden, der eine Kopplung mit einem Wechselstromnetz herstellt.

Zu den Solarzellen jeder Kette 34, 36, 38, 40, 42 und 44 ist eine Bypass-Diode 50, 52, 54, 56, 58 und 60 parallel geschaltet. Die Bypass-Dioden 50 bis 60 befinden sich in einer getrennt vom Solarmodul angebrachten Anschlussbox 62, die in Fig. 1 strichpunktiert angedeutet ist.

Bei der in Fig. 1 dargestellten Schaltungsanordnung sind jeweils drei Bypass-Dioden durch eine parallel geschaltete Diode überbrückt. Die Bypass-Dioden 50, 52, 54 sind zu einer Diode 64 parallel geschaltet. Eine Diode 66 ist zu den Bypass-Dioden 52, 54 und 56 parallel gelegt. Eine Diode 68 ist zu den Bypass-Dioden 54, 56 und 58 parallel geschaltet. Schließlich ist eine Diode 70 parallel zu den Bypass-Dioden 56, 58 und 60 geschaltet. Bei den Dioden 66, 64, 68 und 70 handelt es sich ebenfalls um Bypass-Dioden, die allerdings jeweils nicht zu einer Kette sondern zu drei Ketten parallel geschaltet sind. Um die Dioden 64, 66, 68 und 70 von den Bypass-Dioden 50 bis 60 besser unterscheiden zu können, werden sie als Dioden oder als weitere Dioden bezeichnet.

Die Bypass-Dioden 50 bis 60 sind gegenüber den jeweils parallel geschatteten Ketten 34 bis 44 bei aktiven, d. h. angestrahlten Solarzellen in den Ketten in Sperrrichtung gepolt, d. h. nichtleitend. Die Anschlussstelle 48 hat z. B. positives Potential und die Anschlussstelle 46 negatives. Wenn eine der Ketten 34 bis 44 nicht mehr aktiv ist, weil sie zum Beispiel abgeschattet ist, befindet sie sich im Sperrzustand und leistet keinen Beitrag mehr zur Spannung bzw. zum Strom des Solarmoduls. Die übrigen, noch aktiven Ketten erzeugen noch Strom, der über die Bypass-Diode der nicht aktiven Kette fließt. Dabei entsteht am inneren Widerstand der in Durchlassrichtung arbeitenden Bypass-Diode ein Spannungsabfall, durch den die Energieausbeute des Solarmoduls vermindert wird. Weiterhin entsteht in der stromführenden Bypass-Diode Verlustwärme, die abgeführt werden muss, damit die zulässige Temperatur in der Bypass-Diode nicht überschritten wird. Die Bypass-Dioden 50 bis 60 und die weiteren Dioden 64 bis 70 sind Schottky-Dioden, deren Innenwiderstände im Durchlassbetrieb gering sind, wodurch die Wärmeverluste gering gehalten werden sollen.

Wenn bei der in Fig. 1 dargestellten Anordnung eine Kette nicht aktiviert ist, fließt der von den übrigen Ketten und z. B. von einem weiteren Solarmodul erzeugte Strom über nur eine Bypass-Diode. Wenn zwei Ketten der dargestellten Anordnung nicht aktiv sind, sind zwei Bypass-Dioden stromführend. Sind drei Ketten der in Fig. 1 dargestellten Anordnung z. B. durch Abschattung nicht aktiv, dann sind in Abhängigkeit von der Lage der jeweils nicht aktiven Kette in der Reihenfolge der Ketten entweder nur eine, zwei oder drei der Dioden 50 bis 60 bzw. 64 bis 70 aktiv. Da aber die Wahrscheinlichkeit, dass in einem Solarmodul drei oder mehr Ketten, die nicht aneinandergrenzen, durch Abschattung nicht aktiv sind, gering ist, sind bei der Anordnung gemäß Fig. 1 im Allgemeinen trotz Abschattung von drei oder mehr Ketten höchstens zwei Dioden stromdurchflossen.

In Fig. 1 ist eine weitere Möglichkeit zur Reduzierung der stromdurchflossenen Dioden bei Abschattung von Ketten dargestellt. Diese weitere Möglichkeit besteht darin, dass bereits zu jeweils zwei in Serie angeordneten Ketten 34, 36 bzw. 38, 40 bzw. 42, 44 eine Diode 72 bzw. 74 bzw. 76 parallel geschaltet ist. Diese zusätzliche Möglichkeit, deren schaltungstechnischer Aufbau in Fig. 1 gestrichelt dargestellt ist, bewirkt, dass bei Abschattung zweier benachbarter Ketten nur eine Diode stromleitend wird. Die Anordnung der Dioden 72, 74 und 76 parallel zu den entsprechenden Ketten und deren Bypass-Dioden bewirkt auch ohne die Dioden 64, 66, 68 und 70 eine Reduzierung der stromleitenden Dioden bei Abschattung von Ketten. In Verbindung mit den Dioden 64 bis 70 lässt sich damit eine erhebliche Reduzierung der stromleitenden Dioden bei beliebiger Anzahl der abgeschatteten Ketten und deren Lage in der Reihenfolge erreichen.

Es ist im Übrigen möglich, weitere Dioden den Ketten 34 bis 44 bzw. deren Bypass-Dioden derart parallel zu schalten, dass unabhängig von der Anzahl der abgeschatteten Ketten immer nur eine Diode stromführend ist. Bei einer solchen Anordnung sind auch noch Dioden vorzusehen, die nicht nur zwei oder drei sondern auch vier und fünf Ketten in Parallelschaltung überbrücken. Für die Verwendung einer solchen Anordnung sind Platzgründe in der Anschlussbox und wirtschaftliche Gründe bezüglich des Aufwands maßgebend.

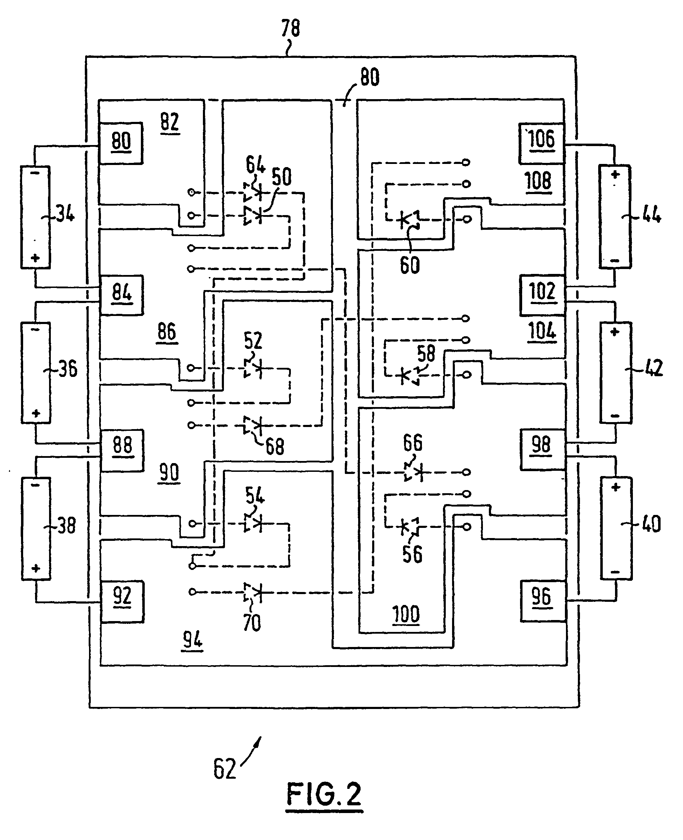

In Fig. 2 ist schematisch die Anschlussbox 62 mit einer in einem Plastikgehäuse 78 angeordneten Leiterplatte 80 dargestellt. Von der Leiterplatte 80 ist eine ebene Seite gezeigt. Die Kette 34 ist mit ihrem Minuspol über eine nicht näher bezeichnete Leitung mit einer Anschlussstelle 80 verbunden, die zu einer breitflächigen Leiterbahn 82 auf der einen Plattenseite gehört. Auf der gleichen Plattenseite befindet sich eine Anschlussstelle 84 einer breitflächigen Leiterbahn 86. Mit der Anschlussstelle 84 sind der positive Pol der Kette 34 und der negative Pol der Kette 36 über nicht näher bezeichnete Leitungen verbunden. Eine weitere Anschlussstelle 88 einer breitflächigen Leiterbahn 90 ist mit dem positiven Pol der Kette 36 und dem negativen Pol der Kette 38 verbunden. Der positive Pol der Kette 38 ist über eine Leitung an eine Anschlussstelle 92 einer breitflächigen Leiterbahn 94 angeschlossen, die sich über die gesamte Breite der Leiterplatte 80 erstreckt. Die Leiterbahnen 82, 86 und 90 verlaufen nur bis etwa zur Mitte der Leiterplatte 80. Die Anschlussstellen 80, 84, 88 und 92 befinden sich auf der gleichen Seite der Leiterplatte 80. Die Leiterbahn 94 besitzt eine zweite Anschlussstelle 96 auf der den Anschlussstellen 80 bis 92 gegenüberliegenden Seite der Leiterplatte 80. Mit der Anschlusstelle 96 ist der negative Pol der Kette 40 über eine nicht näher bezeichnete Leitung verbunden. Der positive Pol der Kette 40 steht mit einer Anschlussstelle 98 einer breitflächigen Leiterbahn 100 in Verbindung, die etwa in der Mitte der Leiterplatte 80 in einem elektrisch isolierenden Abstand an die Leiterbahnen 90 und 94 angrenzt. Mit der Anschlussstelle 98 ist auch der negative Pol der Kette 42 über eine nicht näher bezeichnete Leitung verbunden. Der positive Pol der Kette 42 ist über eine nicht näher bezeichnete Leitung mit einer Anschlussstelle 102 einer breitflächigen Leiterbahn 104 verbunden. An die Anschlussstelle 102 ist über eine Leitung auch der negative Pol der Kette 44 angeschlossen, deren positiver Pol mit einer Anschlussstelle 106 einer breitflächigen Leiterbahn 108 in Verbindung steht.

Auf der den Leiterbahnen 82, 86, 90, 94, 100, 104 und 108 entgegengesetzten Seite der Leiterplatte 80 sind die Bypass-Dioden 50 bis 60 angeordnet. Die Bypass-Diode 50 ist über durchkontaktierte Löcher in der Leiterplatte 80 an einem Ende mit der Leiterbahn 86 und am anderen Ende mit der Leiterbahn 86 verbunden. In entsprechender Weise ist die Bypass-Diode 52 mit den Leiterbahnen 86 und 90 verbunden. Die Bypass-Diode 54 ist über durchkontaktierte Löcher in der Leiterplatte 80 jeweils mit der Leiterbahn 90 und der Leiterbahn 94 verbunden. Die Bypass-Diode 56 ist über durchkontaktierte Löcher jeweils mit der Leiterbahn 94 und der Leiterbahn 100 verbunden. In entsprechender Weise ist die Bypass-Diode 58 mit den Leiterbahnen 100 und 104 verbunden. Schließlich ist auch die Bypass-Diode 60 über durchkontaktierte Löcher in der Leiterplatte 80 mit der Leiterbahn 104 und der Leiterbahn 108 verbunden.

Die Diode 64 ist mit der Anode an die Leiterbahn 82 und mit der Kathode an die Leiterbahn 94 angeschlossen. Die Diode 66 ist mit der Anode an die Leiterbahn 86 und mit der Kathode an die Leiterbahn 100 gelegt. Die Diode 68 ist mit der Anode an die Leiterbahn 90 und mit der Kathode an die Leiterbahn 104 angeschlossen. Die Diode 70 ist mit der Anode an die Leiterbahn 94 und mit der Kathode an die Leiterbahn 108 gelegt.

Die Bypass-Dioden 50 bis 60 und die Dioden 64 bis 70 sind Schottky-Dioden und liegen jeweils auf einer nicht näher dargestellten Metallschicht auf der Leiterplatte 80 auf. Die Metallschichten nehmen einen großen Teil der beim Stromfluss in der jeweiligen Diode entstehenden Wärme auf und geben sie durch Konvektion bzw. Strahlung an die Atmosphäre ab. Da die Anzahl der stromführenden Dioden auch bei Abschattung aller Ketten 34 bis 44 auf drei begrenzt ist, wird die Wärme auch bei kompakter Ausbildung der Leiterplatte 80 und der Anschlussbox 62 gut abgeführt. Die Anschlussbox 62 kann daher als Kunststoffdose mit entsprechenden Durchlässen für die zu den Ketten führenden Leitungen ausgebildet sein. Das Solarmodul mit den Ketten 34 bis 44 ist im allgemeinen außerhalb eines Gebäudes angebracht. Die Anschlussbox 62 befindet sich vorzugsweise im Gebäude.

## Patentansprüche

1. Schaltungsanordnung mit mehreren in Serie geschalteten Ketten (34, 36, 38, 40, 42, 44),
wobei jede Kette (34, 36, 38, 40, 42, 44) aus mehreren in Serie geschalteten Solarzellen (10 - 32) besteht und wobei zu jeder Kette (34, 36, 38, 40, 42, 44) von Solarzellen jeweils eine Bypass-Diode (50, 52, 54, 56, 58, 60) parallel geschaltet ist,
wobei die Bypass-Dioden (50, 52, 54, 56, 58, 60) in Serie geschaltet sind,
**dadurch gekennzeichnet,**
**dass** zu jeder möglichen Gruppe von einer festen Anzahl aufeinander folgender Bypass-Dioden (50, 52, 54, 56, 58, 60) der Schaltungsanordnung eine eigene überbrückende Diode (64, 66, 68, 70, 72, 74) parallel geschaltet ist,
**dass** die feste Anzahl mindestens zwei beträgt und innerhalb der Schaltungsanordnung gleich ist,
**dass** die Schaltungsanordnung mehrere überbrückende Dioden (64, 66, 68, 70, 72, 74) aufweist, und
**dass** dann, wenn diejenigen in Reihe geschalteten Ketten (34, 36, 38, 40, 42, 44), deren Bypass-Dioden (50, 52, 54, 56, 58, 60) durch eine der überbrückenden Dioden (64, 66, 68, 70, 72, 74) überbrückt sind, nicht aktiv sind, der Strom der noch aktiven Ketten (34, 36, 38, 40, 42, 44) über die überbrückende Diode (64, 66, 68, 70, 72, 74) fließt, in der dann Verlustleistung auftritt.

2. Schaltungsanordnung nach Anspruch 1,
**dadurch gekennzeichnet,**
**dass** die feste Auzahl drei ist.

3. Schaltungsanordnung nach Anspruch 1 oder 2,
**dadurch gekennzeichnet,**
**dass** die Bypass-Dioden (50 bis 60) und die zu diesen parallelen Dioden (64 bis 70) für zwei oder mehr Ketten (34 bis 44) von Solarzellen auf einer Seite einer Leiterplatte (80) angeordnet sind, die auf deren anderer Seite Leiterbahnen (82, 86, 90, 94, 100, 102, 104) mit Anschlussstellen (80, 84, 88, 92, 96, 98, 102, 106) für externe Leitungen und mit durchkontaktierten Löchern für die Anschlüsse der Bypass-Dioden (50 bis 60) und Dioden (64 bis 70) vorgesehen sind und dass Metallflächen als Auflageflächen für die Bypass-Dioden (50 bis 60) und die zu diesen parallel gelegten Dioden (64 bis 70) auf der Oberfläche der Leiterplatte (80) vorhanden sind.

4. Schaltungsanordnung nach zumindest einem der vorhergehenden Ansprüche,
**dadurch gekennzeichnet,**
**dass** die Bypass-Dioden (50 bis 60) und die zu diesen parallel geschalteten Dioden (64 bis 70) vorzugsweise Schottky-Dioden sind.

5. Schaltungsanordnung nach Anspruch 3,
**dadurch gekennzeichnet,**
**dass** die Leiterplatte (80) mit den Bypass-Dioden (50 bis 60) und den zu diesen parallel geschalteten Dioden (64 bis 70) in einem Kunststoffgehäuse (78) angeordnet ist.

## Claims

1. Circuit arrangement with several series-connected strings (34, 36, 38, 40, 42, 44),
whereby each string (34, 36, 38, 40, 42, 44) consists of several series-connected solar cells (10-32) and whereby to each string (34, 36, 38, 40, 42, 44) of solar cells one bypass diode (50, 52, 54, 56, 58, 60) is connected in parallel respectively,
whereby the bypass diodes (50, 52, 54, 56, 58, 60) are connected in series,
**characterized in**
**that** an own bypassing diode (64, 66, 68, 70, 72, 74) is parallel connected to each possible group of a definite number of successive bypass diodes (50, 52, 54, 46, 58, 60) of the circuit arrangement,
**that** the definite number is at least two and is equal within the circuit arrangement,
**that** the circuit arrangement comprises several bypassing diodes (64, 66, 68, 70, 72, 74), and
**that**, in case the series connected strings (34, 36, 38, 40, 42, 44) the bypass diodes (50, 52, 54, 56, 58, 60) of which are bypassed by one of the bypassing diodes (64, 66, 68, 70, 72, 74) are not active, the current of the still active strings (34, 36, 38, 40, 42, 44) flows over the bypassing diode (64, 66, 68, 70, 72, 74) in which then dissipation power occures.

2. Circuit arrangement according to claim 1,
**characterized in**
**that** the definite number is three.

3. Circuit arrangement according to claim 1 or 2,
**characterized in**
**that** the bypass diodes (50 to 60) and the diodes (64 to 70) parallel thereto for two or more strings (34 to 44) of solar cells are arranged on one side of a printed circuit board (80), on the other side of which printed conductors (82, 86, 90, 94, 100, 102, 104) with connection points (80, 84, 88, 92, 96, 98, 102, 106) for external lines and with plated-through holes for the connections of the bypass diodes (50 to 60) and the diodes (64 to 70) connected parallel thereto are provided on the surface of the printed circuit board (80).

4. Circuit arrangement according to at least one of the preceding claims,
**characterized in**
**that** the bypass diodes (50 to 60) and the diodes (64 to 70) connected in parallel to them are preferably Schottky diodes.

5. Circuit arrangement according to claim 3,
**characterized in**
**that** the printed circuit board (80) with the bypass diodes (50 to 60) and the diodes (64 to 70) connected in parallel to them are arranged in a plastic housing (78).

## Revendications

1. Circuit formé de plusieurs chaînes (34, 36, 38, 40, 42, 44) branchées en série,
chaque chaîne (34, 36, 38, 40, 42, 44) se composant de plusieurs cellules solaires (10-32) branchées en série,
et une diode de dérivation (50, 52, 54, 56, 58, 60) est branchée en parallèle sur chaque chaîne (34, 36, 38, 40, 42, 44) de cellules solaires,
les diodes de dérivation (50, 52, 54, 56, 58, 60) étant branchées en série,
**caractérisé en ce qu'**
une diode de contournement (64, 66, 68, 70, 72, 74) est branchée en parallèle sur chaque groupe possible d'un nombre fixe de diodes de dérivation successives (50, 52, 54, 56, 58, 60),
- le nombre fixe est au moins égal à deux et il est identique dans le circuit,
- le circuit se compose de plusieurs diodes de chevauchement (64, 66, 68, 70, 72, 74) et
lorsque celles des chaînes (34, 36, 38, 40, 42, 44) branchées en série et dont les diodes de dérivation (50, 52, 54, 56, 58, 60) sont contournées par l'une des diodes de contournement (64, 66, 68, 70, 72, 74), ne sont pas actives, le courant des chaînes (34, 36, 38, 40, 42, 44) encore actives passe par la diode de contournement (64, 66, 68, 70, 72, 74) qui engendre une puissance perdue.

2. Circuit selon la revendication 1,
**caractérisé en ce que**
le nombre fixe est égal à trois.

3. Circuit selon la revendication 1 ou 2,
**caractérisé en ce que**
les diodes de dérivation (50-60) et les diodes (64-70) branchées en parallèle sur celles-ci sont prévues d'un côté d'une plaque de circuit (80) pour deux ou plusieurs chaînes (34-44) de cellules solaires, côté qui est à l'opposé de celui des chemins conducteurs (82, 86, 90, 94, 100, 102, 104) avec les points de connexion (80, 84, 88, 92, 96, 98, 102, 106) pour les lignes externes et avec des orifices de mise en contact pour les branchements des diodes de dérivation (50-60) et des diodes (64-70) et des surfaces métalliques existent comme surfaces d'appui pour les diodes de dérivation (50-60) et les diodes (64-70) en parallèle à celles-ci à la surface de la plaque de circuit (80).

4. Circuit selon au moins l'une des revendications précédentes,
**caractérisé en ce que**
les diodes de dérivation (50-60) et les diodes (64-70) branchées en parallèle sur celles-ci sont de préférence des diodes Schottky.

5. Circuit selon la revendication 3,
**caractérisé en ce que**
la plaque de circuit (80) est installée dans un boîtier en matière plastique (70) avec les diodes de dérivation (50-60) et les diodes (64-70) branchées en parallèle sur celles-ci.
